# EUROPEAN PATENT APPLICATION

(11) **EP 4 456 130 A1**
(43) Date of publication of application: **30.10.2024**
(21) Application number: 23208790.8
(22) Date of filing: 09.11.2023
(51) Int. Cl.: H01L 23/48, H01L 23/485, H01L 23/522, H01L 23/528

(54) **SEMICONDUCTOR DEVICE AND METHOD FOR MANUFACTURING THE SAME**

(30) Priority: 25.04.2023 KR 20230054115
(71) Applicant: Samsung Electronics Co., Ltd., Suwon-si, Gyeonggi-do 16677 (KR)
(72) Inventor: KANG, Duckseoung, 16677 Suwon-si, Gyeonggi-do (KR); KWON, Sangdeok, 16677 Suwon-si, Gyeonggi-do (KR); KIM, Gibum, 16677 Suwon-si, Gyeonggi-do (KR)
(74) Representative: Kuhnen & Wacker Patent- und Rechtsanwaltsbüro PartG mbB

(57) **Abstract**

A semiconductor device may include a semiconductor substrate (100), a channel pattern (CH) on a first surface (100a) of the semiconductor substrate (100), source/drain patterns (SD) on the first surface (100a) of the semiconductor substrate (100) and on both sides of the channel pattern (CH), a contact electrode (CT1; CT1') electrically connected to the source/drain patterns (SD), a lower wiring structure (400) on the second surface (100b) of the semiconductor substrate (100), and a through via (210; 210') penetrating the semiconductor substrate (100) and connecting the contact electrode (CT1; CT1') and the lower wiring structure (400) to each other. The lower wiring structure (400) may include a first metal line (510) connected to a first voltage, a second metal line (520) connected to a second voltage, and an auxiliary electrode (530) electrically connected to one of the first metal line (510) and the second metal line (520). The auxiliary electrode (530) may overlap and be insulated from an other of the first metal line (510) and the second metal line (520).

## Description

### BACKGROUND

### Field

The present disclosure relates to a semiconductor device and/or a manufacturing method thereof.

### Description of the Related Art

Various semiconductor devices may be manufactured by using a semiconductor material, and for example, a memory device, a system large scale integration (LSI), and the like may be manufactured. These semiconductor devices may be used in various electronic devices.

As the electronics industry continues to advance, there is a growing demand for specific characteristics of the semiconductor devices. For example, there is an increasing demand for high reliability, high speed, and/or multifunctionality of the semiconductor devices. In order to meet these demand characteristics, structures in a semiconductor device are becoming increasingly complex and integrated.

### SUMMARY

The present disclosure provides a semiconductor device and a method for manufacturing the same having a decoupling capacitor.

In an example embodiment, a semiconductor device may include a semiconductor substrate having a first surface and a second surface opposite to each other; a channel pattern on the first surface of the semiconductor substrate; source/drain patterns on the first surface of the semiconductor substrate, the source/drain patterns being on both sides of the channel pattern; a contact electrode electrically connected to the source/drain patterns; a lower wiring structure on the second surface of the semiconductor substrate; and a through via penetrating the semiconductor substrate and connecting the contact electrode and the lower wiring structure to each other. The lower wiring structure may include a first metal line configured to receive a first voltage, a second metal line configured to receive a second voltage, and an auxiliary electrode electrically connected to one of the first metal line and the second metal line. The auxiliary electrode may overlap an other of the first metal line and the second metal line in a state insulated from the other of the first metal line and the second metal line.

In an example embodiment, a semiconductor device may include a semiconductor substrate having a first surface and a second surface opposite to each other; a channel pattern on the first surface of the semiconductor substrate; source/drain patterns on the first surface of the semiconductor substrate, the source/drain patterns being on both sides of the channel pattern; a contact electrode electrically connected to the source/drain patterns; a lower wiring structure on the second surface of the semiconductor substrate; and a through via penetrating the semiconductor substrate and connecting the contact electrode and the lower wiring structure to each other. The lower wiring structure may include a first metal line configured to receive a first voltage and a second metal line configured to receive a second voltage. Boundaries of the first metal line and the second metal line facing each other may be bent in a same pattern.

In an example embodiment, a method of manufacturing a semiconductor device may include forming a channel pattern and source/drain patterns on a first surface of a semiconductor substrate, the semiconductor substrate having a second surface opposite to the first surface of the semiconductor substrate; forming a through via penetrating the semiconductor substrate; forming a preliminary first lower interlayer insulation layer having an intaglio pattern on the second surface of the semiconductor substrate; forming a first lower via, the first lower via penetrating the preliminary first lower interlayer insulation layer and being connected to the through via, and forming a first metal line and a second metal line filling the intaglio pattern; forming a first lower interlayer insulation layer by partially removing the preliminary first lower interlayer insulation layer to expose the first metal line and the second metal line; stacking a preliminary dielectric layer and a conductive layer on the first metal line and the second metal line such that the preliminary dielectric layer and the conductive layer cover the first metal line and the second metal line; and forming a dielectric layer and an auxiliary electrode by patterning the preliminary dielectric layer and the conductive layer into the dielectric layer and the auxiliary electrode.

According to an embodiment, a decoupling capacitor may be implemented using a power delivery network in a small space. Accordingly, performance of the semiconductor device may be improved.

### BRIEF DESCRIPTION OF THE DRAWINGS

FIG. 1 is a perspective view illustrating a capacitor portion of a semiconductor device according to an embodiment.
FIG. 2 is a top plan view illustrating a semiconductor device according to an embodiment.
FIG. 3A is a cross-sectional view taken along line Y1-Y1' of FIG. 2.
FIG. 3B is a cross-sectional view taken along line Y2-Y2' of Fig. 2.
FIG. 3C is a cross-sectional view taken along line X1-X1' of Fig. 2.
FIG. 4 is an enlarged view of a portion R1 of FIG. 3C.
FIG. 5A to FIG. 5E are cross-sectional views sequentially illustrating a manufacturing method of a semiconductor device according to an embodiment, and are cross-sectional views taken along line Y1-Y1' of FIG. 2.
FIG. 6 is a perspective view illustrating a capacitor portion of a semiconductor device according to another embodiment.
FIG. 7 is a layout view illustrating a capacitor portion of a semiconductor device according to another embodiment.
FIG. 8A to FIG. 8E are cross-sectional views sequentially illustrating a method of manufacturing the semiconductor device according to an embodiment of FIG. 6 or FIG. 7.

### DETAILED DESCRIPTION

The present disclosure will be described more fully hereinafter with reference to the accompanying drawings, in which embodiments are shown. As those skilled in the art would realize, the described embodiments may be modified in various different ways, all without departing from the scope of the present disclosure as defined by the appended claims.

In order to clearly describe the present disclosure, parts or portions that are irrelevant to the description are omitted, and identical or similar constituent elements throughout the specification are denoted by the same reference numerals.

Further, in the drawings, the size and thickness of each element are arbitrarily illustrated for ease of description, and the present disclosure is not necessarily limited to those illustrated in the drawings. In the drawings, the thicknesses of layers, films, panels, regions, areas, etc., are exaggerated for clarity. In the drawings, for ease of description, the thicknesses of some layers and areas are exaggerated.

It will be understood that when an element such as a layer, film, region, area, or substrate is referred to as being "on" or "above" another element, it can be directly on the other element or intervening elements may also be present. In contrast, when an element is referred to as being "directly on" another element, there are no intervening elements present. Further, in the specification, the word "on" or "above" means disposed on or below the object portion, and does not necessarily mean disposed on the upper side of the object portion based on a gravitational direction.

In addition, unless explicitly described to the contrary, the word "comprise" and variations such as "comprises" or "comprising" will be understood to imply the inclusion of stated elements but not the exclusion of any other elements.

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

In the drawing of a semiconductor device according to an embodiment, illustratively, a three-dimensional field effect transistor including a nano wire or a nano sheet, MBCFET^{™} (multi-bridge channel field effect transistor) is shown, but is not limited thereto. In some embodiments, a semiconductor device may include a fin-type transistor (FinFET) including a channel area of a fin-type pattern shape, a tunneling transistor (tunneling FET), or a three-dimensional (3D) transistor.

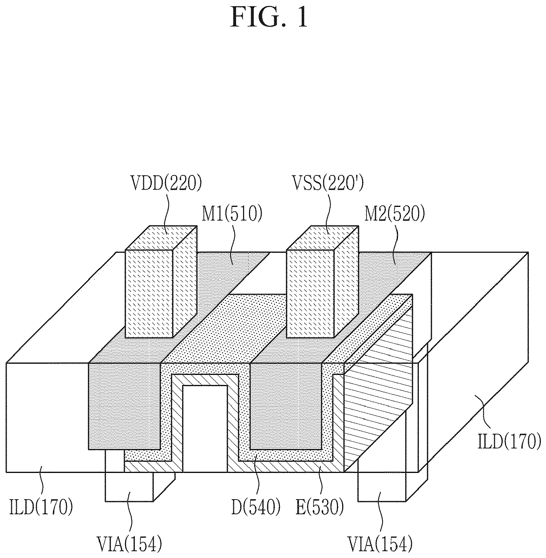

A semiconductor device according to an embodiment will be described with reference to FIG. 1, FIG. 2, FIG. 3A, FIG. 3B, FIG. 3C, and FIG. 4.

FIG. 1 is a perspective view illustrating a capacitor portion of a semiconductor device according to an embodiment.

A capacitor of a semiconductor device according to an embodiment may be a decoupling capacitor and may be implemented using a wiring disposed on one surface of the semiconductor device. The decoupling capacitor may be disposed at a back side of the semiconductor device, and may be formed between a metal power rail M1 (510) (which is an example of the claimed first metal line) and a metal ground rail M2 (520) (which is an example of the claimed second metal line). The decoupling capacitor may include an auxiliary electrode E (530) electrically connected to the metal power rail M1 and surrounding at least a part of the metal ground rail M2 and a dielectric layer D (540) disposed between the metal ground rail M2 and the auxiliary electrode E. The dielectric layer D (540) may include a material having a higher dielectric constant than silicon oxide (SiO₂), such as hafnium oxide (HfO), aluminum oxide (AlO), or tantalum oxide (TaO). The dielectric layer D may be also disposed between the auxiliary electrode E and the metal power rail M1, and the auxiliary electrode E may be connected to a via VIA (154) connected to the metal power rail M1 to be electrically connected to the metal power rail M1. The auxiliary electrode E may be a structure that surrounds both side surfaces and a lower surface of the metal ground rail M2, but example embodiments are not limited thereto. The auxiliary electrode E may have a structure that covers only some of these surfaces or additionally surrounds the upper surface. In addition, the auxiliary electrode E may be electrically connected to the metal ground rail M2, and may have a structure that surrounds the metal power rail M1 in a state insulated from the metal power rail M1. The auxiliary electrode E may be electrically connected to one of the metal power rail M1 and the metal ground rail M2, and the auxiliary electrode E may overlap an other of the metal power rail M1 and the metal ground rail M2 in a state insulated from the other of the metal power rail M1 and the metal ground rail M2. At least corresponding portions of the metal power rail M1 and the metal ground rail M2 may be disposed parallel to each other. The auxiliary electrode E may surround a portion of the metal ground rail M2 parallel to the metal power rail M1.

The metal power rail M1 and the metal ground rail M2 may be connected to a power supply voltage (which is an example of the claimed first voltage) or a ground voltage (which is an example of the claimed second voltage) through lower vias VIA, respectively. Another connection wiring may be interposed between the via VIA and the power supply voltage or the ground voltage. The metal power rail M1 may be connected to a drain terminal of the semiconductor device through an upper via VDD (220), and the metal ground rail M2 may be connected to a source terminal of the semiconductor device through an upper via VSS (220').

An interlayer insulation layer ILD (170) may be disposed around the metal power rail M1, the metal ground rail M2, the auxiliary electrode E, the dielectric layer D, the upper vias VDD, VSS and the lower vias VIA.

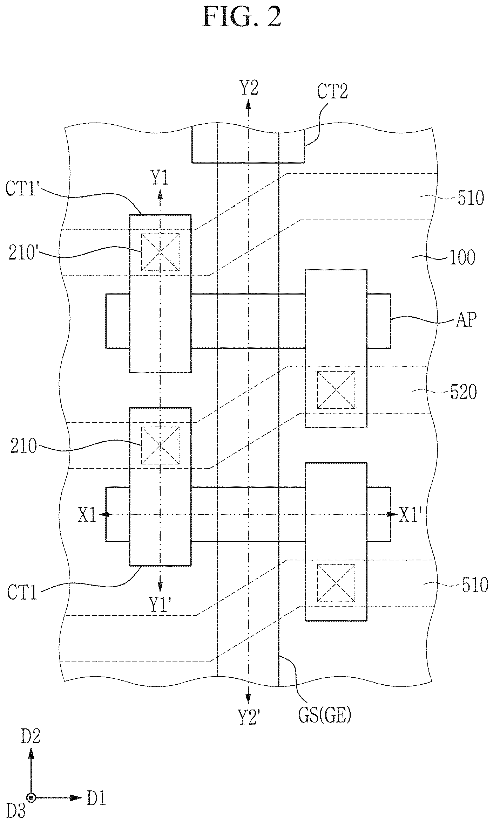

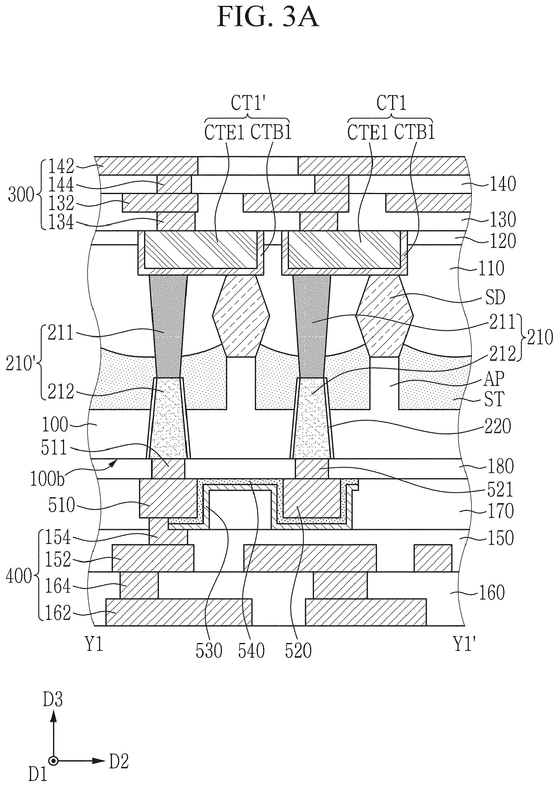

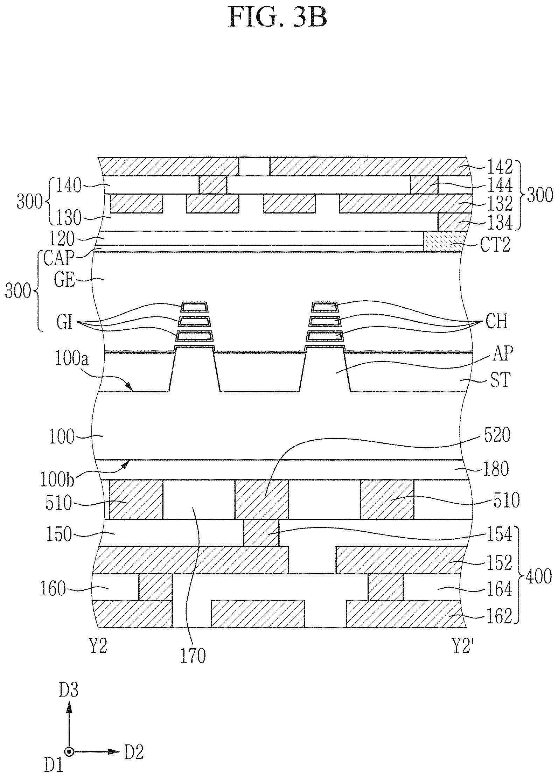

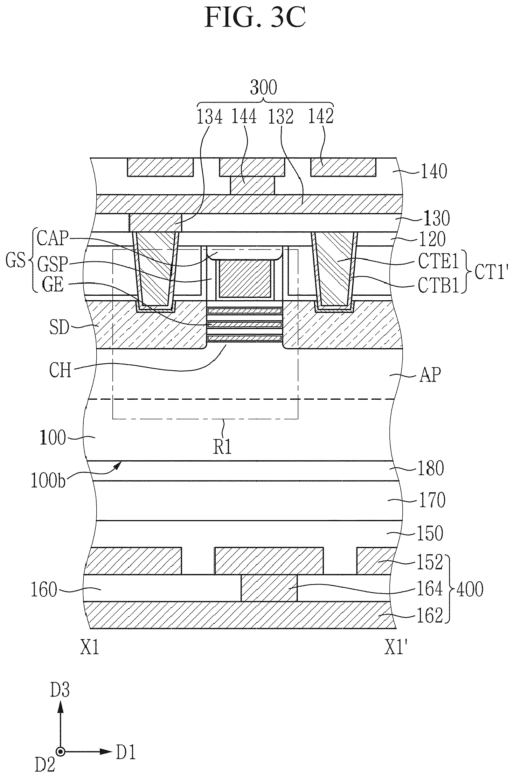

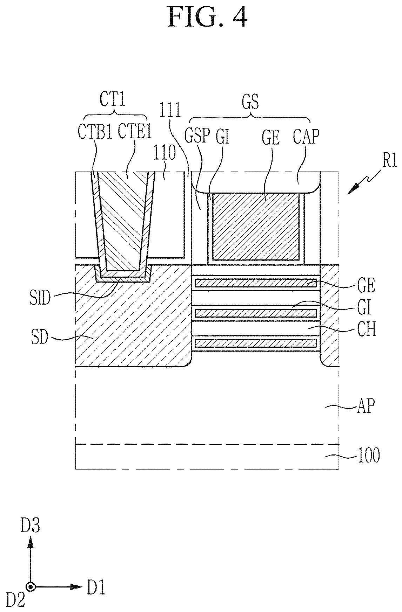

FIG. 2 is a top plan view illustrating a semiconductor device according to an embodiment. FIG. 3A is a cross-sectional view taken along line Y1-Y1' of FIG. 2. FIG. 3B is a cross-sectional view taken along line Y2-Y2' of Fig. 2. FIG. 3C is a cross-sectional view taken along line X1-X1' of Fig. 2. FIG. 4 is an enlarged view of a portion R1 of FIG. 3C.

Referring to FIG. 2 and FIG. 3A to FIG. 3C, a semiconductor device according to an embodiment may include a semiconductor substrate 100, active patterns AP disposed on the semiconductor substrate 100, an isolation layer ST disposed between the active patterns AP, channel patterns CH (see Fig. 3B and Fig. 3C) disposed on the active patterns AP, a gate structure GS surrounding the channel patterns CH, source/drain patterns SD (see Fig. 3A and Fig. 3C) disposed at both sides of the channel patterns CH, first and second interlayer insulation layers 110 and 120 disposed on the source/drain patterns SD, an upper wiring structure 300 disposed on the second interlayer insulation layer 120, a metal power rail 510 disposed below the semiconductor substrate 100, a metal ground rail 520, an auxiliary electrode 530 and a dielectric layer 540 for forming a capacitor therebetween, a lower wiring structure 400, and a through via 210 and 210' penetrating the semiconductor substrate 100.

The semiconductor substrate 100 may include a semiconductor material. For example, the semiconductor substrate 100 may include a group IV semiconductor, a group III-V compound semiconductor, a group II-VI compound semiconductor, and the like. For example, the semiconductor substrate 100 may include a semiconductor such as Si or Ge, or a compound semiconductor such as SiGe, SiC, GaAs, InAs, or InP. The semiconductor substrate 100 may have an upper surface parallel to a first direction D1 and a second direction D2.

The semiconductor substrate 100 may include a first surface 100a and a second surface 100b. The first surface 100a and second surface 100b may be opposite to each other. In embodiments described later, the first surface 100a may be referred to as a front side of the semiconductor substrate 100, and the second surface 100b may be referred to as a back side of the semiconductor substrate 100. In some embodiments, a logic circuit of a cell region may be implemented on the first surface 100a of the semiconductor substrate 100.

The active patterns AP may be positioned at an upper portion of the semiconductor substrate 100. The active patterns AP are portions of the semiconductor substrate 100, and may be vertically protruding portions. The active patterns AP may be PMOSFET regions or NMOSFET regions. The active patterns AP may protrude from the first surface 100a of the semiconductor substrate 100 along a third direction D3. The active patterns AP may be spaced apart from each other along the second direction D2. The active patterns AP may include semiconductors such as Si, Ge, and may include a group IV semiconductor, a group III-V compound semiconductor, a group II-VI compound semiconductor, and the like.

The isolation layer ST may fill trenches between the active patterns AP. The isolation layer ST may be formed to cover side surfaces of the active patterns AP. The isolation layer ST according to the embodiment is illustrated as entirely covering the side surfaces of the active patterns AP, but is not limited thereto, and the isolation layer ST may partially cover the side surfaces of the active patterns AP. In this case, some of the active patterns AP may protrude further than the upper surface of the isolation layer ST in the third direction D3. The isolation layer ST may include, for example, silicon oxide (SiO₂), silicon nitride (SiN), silicon nitride oxide (SiON) or combination thereof.

The channel patterns CH may be positioned on a plurality of active patterns AP. The channel patterns CH may be spaced apart from the active patterns AP in the third direction D3. Although it is illustrated that three channel patterns CH are disposed in the third direction D3, it is not limited thereto. For example, four or more or two or fewer channel patterns CH may be disposed to be spaced apart from each other along the third direction D3.

The channel patterns CH may include the same material as the active patterns AP. For example, the channel patterns CH may include semiconductors such as Si, Ge, and may include a group IV semiconductor, a group III-V compound semiconductor, a group II-VI compound semiconductor, and the like. However, they are not limited thereto, and the channel patterns CH may include a material different from that of the active patterns AP.

The gate structure GS may be positioned on the first surface 100a of the semiconductor substrate 100. The gate structure GS may cross the plurality of active patterns AP. The gate structure GS may extend in the second direction D2. The gate structures GS may be spaced apart from each other in the first direction D1. The gate structure GS may be positioned at both sides of the source/drain patterns SD.

Referring further to FIG. 4, each gate structure GS may include a gate electrode GE, a gate insulating pattern GI between the gate electrode GE and the channel patterns CH, a gate spacer GSP on side surfaces of the gate electrode GE, and a gate capping pattern CAP on an upper surface of the gate electrode GE.

The gate electrode GE may be positioned on the first surface 100a of the semiconductor substrate 100. The gate electrode GE may extend in the second direction D2. Respective gate electrodes GE may be spaced apart from each other in the first direction D1. The gate electrode GE may cross the active patterns AP. The gate electrode GE may surround respective channel patterns CH.

At least a portion of the gate electrode GE may be positioned on a stacked structure of the channel patterns CH. Another portion of the gate electrode GE may be formed to cover both side surfaces of the stacked structure of the channel patterns CH. Four surfaces of the channel patterns CH may be surrounded by a gate electrode GE.

The gate electrode GE may include at least one of a metal, a metal alloy, a conductive metal nitride, a doped semiconductor material, a conductive metal oxide, and a conductive metal nitride oxide. The gate electrode GE may include, for example, titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten W, aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and a combination thereof, but is not limited thereto. The conductive metal oxide and the conductive metal oxynitride may include oxidized forms of the above-mentioned materials, but are not limited thereto.

Referring to FIG. 4, the gate insulating pattern GI may surround the gate electrode GE. The gate insulating pattern GI may be positioned between the gate electrode GE and the channel patterns CH. The gate insulating pattern GI may extend between the gate electrode GE and the gate spacer GSP. An uppermost surface of the gate insulating pattern GI may be positioned at the same or substantially the same level as an upper surface of the gate electrode GE. The gate insulating pattern GI may be interposed between the upper surface of the channel patterns CH and the gate electrode GE.

The gate insulation pattern GI may include at least one of silicon oxide (SiO₂), silicon nitride (SiN), silicon nitride oxide (SiON), or high dielectric layer. High dielectric layer may include a material having a higher dielectric constant than silicon oxide (SiO₂), such as hafnium oxide (HfO), aluminum oxide (AlO), or tantalum oxide (TaO).

The gate spacer GSP may be positioned next to a sidewall of the gate electrode GE. The gate spacer GSP may not be disposed next to the sidewall of the gate electrode GE disposed between the active patterns AP and the channel patterns CH. The gate spacer GSP may not be disposed next to the sidewall of the gate electrode GE between the channel patterns CH adjacent to each other in the third direction D3.

The gate capping pattern CAP may be positioned on the gate electrode GE and the gate spacer GSP. An upper surface of the gate capping pattern CAP may be on the same plane as an upper surface of the first interlayer insulation layer 110. Unlike as shown, the gate capping pattern CAP may be disposed between the gate spacers GSP. That is, the gate spacer GSP may cover the side surface of the gate capping pattern CAP. The gate spacer GSP and the gate capping pattern CAP each may include at least one of silicon oxide (SiO₂), silicon nitride (SiN) and silicon nitride oxide (SiON).

The source/drain patterns SD may be formed to cover both side surfaces of the stacked structure of the gate electrode GE and the channel patterns CH. In this case, the source/drain patterns SD may be positioned at both sides of the channel patterns CH along the first direction D1.

The source/drain patterns SD may be epitaxial patterns formed by a selective epitaxial growth process using respective active patterns AP as a seed. The source/drain patterns SD may include for example, at least one of silicon, silicon germanium, and silicon carbide. The channel patterns CH may be some of respective active patterns AP extending between the source/drain patterns SD. The source/drain patterns SD may serve as a source/drain of a transistor using the channel patterns CH as a channel area.

A etch stop film 111 may be positioned on a side surface of the gate spacer GSP and on the upper surface of the source/drain patterns SD. The etch stop layer 111 may include for example, at least one of silicon nitride (SiN), silicon nitride oxide (SiON), silicon carbonate nitride (SiCN), silicon boronnitride (SiBN), silicon carbonate (SiOC), and a combination thereof.

The first interlayer insulation layer 110 may be positioned on the etch stop film 111. The first interlayer insulation layer 110 may cover the source/drain patterns SD. The first interlayer insulation layer 110 may cover an upper surface of the isolation layer ST.

The second interlayer insulation layer 120 may be positioned on the first interlayer insulation layer 110. The second interlayer insulation layer 120 may cover the upper surface of the gate capping pattern CAP. The first and second interlayer insulation layers 110 and 120 may include for example, at least one of silicon oxide (SiO₂), silicon nitride (SiN), silicon nitride oxide (SiON), and a low dielectric constant material. The low dielectric constant material include for example, Fluorinated TetraEthylOrthoSilicate (FTEOS), HydrogenSilsesQuioxane (HSQ), Bis-benzoCycloButene (BCB), TetraMethylOrthoSilicate (TMOS), or combination thereof, but is not limited thereto.

The second interlayer insulation layer 120 may cover side surfaces of first contact electrodes CT1 and CT1'. In addition, an upper surface of the second interlayer insulation layer 120 may be positioned at the same or substantially the same level as upper surfaces of the first contact electrodes CT1 and CT1'. In FIG. 3A, the second interlayer insulation layer 120 and the first interlayer insulation layer 110 are shown as different layers, but the second interlayer insulation layer 120 may be integrally formed with the first interlayer insulation layer 110 without a boundary surface therebetween.

The first contact electrodes CT1 and CT1' may pass through the first interlayer insulation layer 110 and the second interlayer insulation layer 120 to be connected to source/drain patterns SD. The first contact electrodes CT1 and CT1' may be positioned at both sides of each gate structure GS. The first contact electrodes CT1 and CT1' may have a bar shape extending in the second direction D2.

Each of the first contact electrodes CT1 and CT1' may be connected to a plurality of source/drain patterns SD spaced apart from each other in a second direction D2. For example, as shown in FIG. 4, the bottom surfaces of the first contact electrodes CT1 and CT1' may be positioned at a level similar to the lower surface of the uppermost channel pattern among the channel patterns CH. However, the bottom surfaces of the first contact electrodes CT1 and CT1' may be higher or lower than the lower surface of the uppermost channel pattern among the channel patterns CH. The first contact electrodes CT1 and CT1' may be connected to the through vias 210 and 210'.

The first contact electrodes CT1 and CT1' according to the embodiment may include a first conductive pattern CTE1 and a first barrier pattern CTB1 surrounding it.

The first conductive pattern CTE1 may include for example, at least one of a metal, a metal alloy, a conductive metal nitride, a conductive metal carbide, a conductive metal oxide, a conductive metal carbonitride, and a two-dimensional (2D) material.

The first barrier pattern CTB1 may cover sidewalls and bottom surfaces of first conductive patterns CT1 and CT1'. The first barrier pattern CTB1 may include a metal, a metal alloy, and a conductive metal nitride. The metal may include at least one of titanium (Ti), tantalum (Ta), tungsten W, nickel (Ni), cobalt (Co) and platinum (Pt). The conductive metal nitride may include at least one of titanium nitride (TiN), tantalum nitride (TaN), tungsten nitride (WN), nickel nitride (NiN), cobalt nitride (CoN) and platinum nitride (PtN).

Although the first contact electrodes CT1 and CT1' according to the embodiment are illustrated as being a double layered film including the first conductive pattern CTE1 and the first barrier pattern CTB1, but this is for illustrative purposes only and is not intended to be limiting.

A metal silicide film SID may be further disposed between the source/drain patterns SD and the first contact electrodes CT1 and CT1'. The metal silicide film SID may include a metal silicide.

Referring back to FIG. 3A to FIG. 3C, a second contact electrode CT2 may be positioned within the second interlayer insulation layer 120. The second contact electrode CT2 may pass through the second interlayer insulation layer 120 and the gate capping pattern CAP to be connected to the gate electrode GE. The upper surfaces of the first contact electrodes CT1 and CT1' and the second contact electrode CT2 may be positioned at the same or substantially the same level as the upper surface of the second interlayer insulation layer 120. For example, the upper surfaces of the first contact electrodes CT1 and CT1' and the second contact electrode CT2 may be substantially at the same height as the upper surface of the second interlayer insulation layer 120 with respect to the second surface 100b of the semiconductor substrate 100.

The first contact electrodes CT1 and CT1' and the second contact electrode CT2 may include the same conductive material. The first contact electrodes CT1 and CT1' and the second contact electrode CT2 may include a metallic material. For example, the first contact electrodes CT1 and CT1' and the second contact electrode CT2 may include for example, at least one of a metal, a metal alloy, a conductive metal nitride, a conductive metal carbide, a conductive metal oxide, a conductive metal carbonitride, and a two-dimensional (2D) material.

The upper wiring structure 300 may be positioned on the second interlayer insulation layer 120. The upper wiring structure 300 may include a first upper wirings 132, a first upper vias 134, a second upper wirings 142, a second upper vias 144, a third interlayer insulation layer 130, and a fourth interlayer insulation layer 140.

In more detail, the third interlayer insulation layer 130 may be positioned on the second interlayer insulation layer 120. The third interlayer insulation layer 130 may cover the upper surfaces of the first contact electrodes CT1 and CT1' and the second contact electrode CT2.

The first upper wirings 132 and the first upper vias 134 may be positioned within the third interlayer insulation layer 130. The first upper wirings 132 may pass through an upper portion of the third interlayer insulation layer 130. Upper surfaces of the first upper wirings 132 may be positioned at the same or substantially the same level as an upper surface of the third interlayer insulation layer 130. That is, the upper surfaces of the first upper wirings 132 may be at a substantially equal height to the upper surface of the third interlayer insulation layer 130 with respect to the second surface 100b of the semiconductor substrate 100.

The first upper vias 134 may be positioned between the first contact electrodes CT1 and CT1' and the first upper wirings 132 and between the second contact electrode CT2 and the first upper wirings 132. The first upper vias 134 may penetrate a back side of the third interlayer insulation layer 130. Each of the first contact electrodes CT1 and CT1' and the second contact electrode CT2 may be electrically connected to the first upper wirings 132 through the first upper vias 134.

The fourth interlayer insulation layer 140 may be positioned on the third interlayer insulation layer 130. The fourth interlayer insulation layer 140 may cover the upper surfaces of the first upper wirings 132.

The second upper wirings 142 and the second upper vias 144 may be positioned within the fourth interlayer insulation layer 140. The second upper wirings 142 may pass through an upper portion of the fourth interlayer insulation layer 140. Upper surfaces of the second upper wirings 142 may be positioned at the same or substantially the same level as an upper surface of the fourth interlayer insulation layer 140. That is, the upper surfaces of the second upper wirings 142 may be at a substantially equal height to the upper surface of the fourth interlayer insulation layer 140 with respect to the second surface 100b of the semiconductor substrate 100.

The second upper vias 144 may be positioned between the first upper wirings 132 and the second upper wirings 142. The second upper vias 144 may penetrate a back side of the fourth interlayer insulation layer 140. Each of the first upper wirings 132 may be electrically connected to the second upper wirings 142 through the second upper vias 144.

The third and fourth interlayer insulation layers 130 and 140 may include for example, at least one of silicon oxide (SiO₂), silicon nitride (SiN), silicon nitride oxide (SiON), or low dielectric layers. The first and second upper wirings 132 and 142, and the first and second upper vias 134 and 144 may include at least one of a metal and a conductive metal nitride.

The metal power rail 510, the metal ground rail 520, the auxiliary electrode 530 and the dielectric layer 540 for forming a capacitor therebetween, and the lower wiring structure 400 may be disposed on the second surface 100b of the semiconductor substrate 100. The metal power rail 510, the metal ground rail 520, and the lower wiring structure 400 may be, for example, a power delivery network supplying a power supply voltage to the source/drain patterns SD.

The metal power rail 510 and the metal ground rail 520 may be positioned on a first lower interlayer insulation layer 180 positioned on the second surface 100b of the semiconductor substrate 100. The metal power rail 510 and the metal ground rail 520 may be connected to the through vias 210 and 210' penetrating the semiconductor substrate 100 through first lower vias 511 and 521 (which are examples of the claimed first via) penetrating the first lower interlayer insulation layer 180, respectively. The dielectric layer 540 and the auxiliary electrode 530 may be positioned on the first lower interlayer insulation layer 180, the metal power rail 510 and the metal ground rail 520. The dielectric layer 540 and the auxiliary electrode 530 may be disposed to surround left and right side surfaces and a lower surface of the metal ground rail 520 and to partially surround the metal power rail 510. The auxiliary electrode 530 may be electrically connected to the metal power rail 510 through a second lower via 154 (which is an example of the claimed second via). In some embodiments, the auxiliary electrode 530 may be electrically connected to the metal ground rail 520, and have a structure that surrounds at least a part of the metal power rail 510 in a state insulated from the metal power rail 510 by the dielectric layer 540. The auxiliary electrode 530 may be electrically connected to one of the metal power rail 510 and the metal ground rail 520, and the auxiliary electrode 530 may overlap an other of the metal power rail 510 and the metal ground rail 520 in a state insulated from the other of the metal power rail 510 and the metal ground rail 520. A second lower interlayer insulation layer 170 burying the metal power rail 510, the metal ground rail 520, the dielectric layer 540, and the auxiliary electrode 530 may be positioned on the first lower interlayer insulation layer 180. The metal power rail 510, the metal ground rail 520, the first lower vias 511 and 521 may include a metal (e.g., copper). The auxiliary electrode 530 may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten W, aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and a combination thereof, but is not limited thereto. The dielectric layer 540 may include a material having a higher dielectric constant than silicon oxide (SiO₂), such as hafnium oxide (HfO), aluminum oxide (AlO), or tantalum oxide (TaO), but is not limited thereto.

The metal power rail 510 and the metal ground rail 520, the dielectric layer 540 and the auxiliary electrode 530, the first lower vias 511 and 521, and the first and second lower interlayer insulation layers 180 and 170 may be defined as a capacitor forming structure.

The lower wiring structure 400 may be positioned on the capacitor forming structure. The lower wiring structure 400 may include lower wirings 152 and 162, second lower vias 154 and 164 and third and fourth lower interlayer insulation layers 150 and 160. The lower wirings 152 and 162 and the lower vias 154 and 164 may include metal (e.g., copper). The lower wirings 152 and 162 and the lower vias 154 and 164 may be electrically connected to the metal power rail 510 or the metal ground rail 520.

The first to fourth lower interlayer insulation layers 180, 170, 150, and 160 may include for example, at least one of silicon oxide (SiO₂), silicon nitride (SiN), silicon nitride oxide (SiON), or low dielectric layers.

In the above, the capacitor forming structure and the lower wiring structure 400 have been described as separate components, but the capacitor forming structure may be included as a part of the lower wiring structure 400. That is, the lower wiring structure 400 may include the metal power rail 510 configured to receive the power supply voltage and the metal ground rail 520 configured to receive the ground voltage, the dielectric layer 540 and the auxiliary electrode 530 electrically connected to one of the metal power rail 510 and the metal ground rail, the first lower vias 511 and 521, and the first and second lower interlayer insulation layers 180 and 170. In addition, the decoupling capacitor may be formed by a part of wiring included in the lower wiring structure 400. In addition, depending on embodiments, the capacitor forming structure may be located in the middle or below the lower wiring structure 400.

The through vias 210 and 210' may be positioned within the semiconductor substrate 100. The through vias 210 and 210' may penetrate the first interlayer insulation layer 110, the isolation layer ST and the semiconductor substrate 100 and connect the first contact electrodes CT1 and CT1' and the capacitor forming structure to each other. The through vias 210 and 210' may be electrically connected to the first contact electrodes CT1 and CT1' and the capacitor form ing structure, respectively. The through vias 210 and 210' may extend in the first direction D1.

The through vias 210 and 210' may include a first portion 211 and a second portion 212. The first portion 211 may be positioned between the first contact electrodes CT1 and CT1' and the second portion 212, and the second portion 212 may be positioned between the first portion 211 and the capacitor forming structure. The first portion 211 may pass through the first interlayer insulation layer 110 and the isolation layer ST, and the second portion 212 may pass through the isolation layer ST and the semiconductor substrate 100. A width of the first portion 211 may decrease as it goes downward (as it approaches the second portion 212), and a width of the second portion 212 may increase as it goes downward (as it approaches the second surface 100b). Although not shown, the second portion 212 may be positioned so as to extend long in the first direction D1 and cross the gate structure GS in an insulated state. That is, the second portion 212 may extend longer in the first direction D1 than the first portion 211. A side insulation layer 220 may disposed between the second portion 212 and the semiconductor substrate 100 to insulate them.

The first portion 211 of the through vias 210 and 210' may include a same material as the first contact electrodes CT1 and CT1'. The first portion 211 of the through via 210 and 210' may include, for example, at least one of a metal, a metal alloy, a conductive metal nitride, a conductive metal carbide, a conductive metal oxide, and a conductive metal carbonitride. However, it is not limited thereto, and the first portion 211 of the through via 210 and 210' may include a different material from that of the first contact electrode CT1 and CT1'.

The second portion 212 of the through vias 210 and 210' may include a same material as the first portion 211. The second portion 212 of the through via 210 and 210' may include, for example, at least one of a metal, a metal alloy, a conductive metal nitride, a conductive metal carbide, a conductive metal oxide, and a conductive metal carbonitride. However, it is not limited thereto, and the second portion 212 of the through vias 210 and 210' may include a different material with the first portion 211 of the through vias 210 and 210'.

In summary, the through vias 210 and 210' of the semiconductor device according to an embodiment may be electrically connected to the capacitor forming structure and the lower wiring structure 400. In addition, the through vias 210 and 210' may be electrically connected to the first contact electrodes CT1 and CT1'. That is, the first contact electrodes CT1 and CT1' may be electrically connected to the lower wiring structure 400 through the through vias 210 and 210'. The lower wiring structure 400 and the capacitor forming structure may apply a power supply voltage or a ground voltage to the first contact electrodes CT1 and CT1' through the through vias 210 and 210'.

In this case, since the capacitor forming structure and the lower wiring structure 400 are positioned on the back side of the semiconductor substrate 100, the capacitor forming structure and the lower wiring structure 400 may not occupy a separate area within the semiconductor device. Accordingly, a gap for insulation between the wire layers of the upper wiring structure 300 disposed on the front surface of the semiconductor substrate 100 may be easily secured.

The through via 210 and 210' may be formed by depositing a conductive material in the through hole penetrating the first interlayer insulation layer 110 and the isolation layer ST and the through hole penetrating the semiconductor substrate 100.

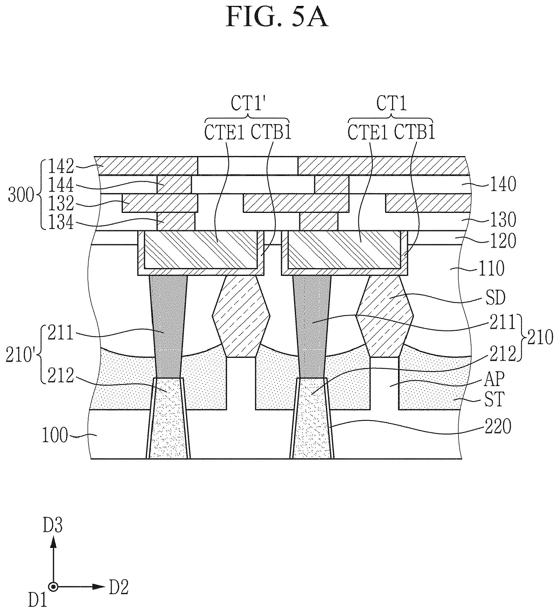

Hereinafter, a manufacturing method of a semiconductor device according to an embodiment, will be described with reference to FIG. 5A to FIG. 5E.

FIG. 5A to FIG. 5E are cross-sectional views sequentially illustrating a manufacturing method of a semiconductor device according to an embodiment, and are cross-sectional views taken along line Y1-Y1' of FIG. 2.

Referring to FIG. 5A, a stacked structure may be formed by repeatedly stacking a sacrificial layer and the semiconductor layer on the semiconductor substrate 100, and preliminary active patterns may be formed by photo-etching the stacked structure and the semiconductor substrate 100. The preliminary active patterns may be separated by the trench. Subsequently, the isolation layer ST is formed to partially fill the inside of the trench TR1, and the channel patterns CH, the gate structure GS (see FIG. 3C), and the source/drain patterns SD on the active patterns AP may be formed. Subsequently, the first interlayer insulation layer 110 may be formed to cover the isolation layer ST and the source/drain patterns SD.

The source/drain patterns SD may be formed by using an epitaxial growth method. The source/drain patterns SD may include silicon germanium (SiGe). However, they are not limited thereto, and the material of the source/drain patterns SD may be variously changed.

Referring to FIGS. 3C and 5A, the gate structure GS may be formed by removing a sacrificial layer and forming the gate insulation pattern GI, the gate electrode GE, a gate capping pattern, etc. in a space where the sacrificial layer is removed. The gate electrode GE may be formed by using an atomic layer deposition (ALD) process, a chemical vapor deposition (CVD) process, and the like. Accordingly, the gate structure GS may cover the upper surface of the channel patterns CH, and may cover both side surfaces of the channel patterns CH. The source/drain patterns SD may be disposed at both sides of each gate structure GS.

Referring to FIG. 5A, the first portion 211 of the through via 210 and 210' penetrating the first interlayer insulation layer 110 and the isolation layer ST may be formed. A through hole is formed by photo-etching the first interlayer insulation layer 110 and the isolation layer ST, and the first portion 211 may be formed by filling the through hole with a conductive material including a metal or a metal alloy.

Referring to FIG. 5A, the second interlayer insulation layer 120 may be formed on the first interlayer insulation layer 110, and the first contact electrodes CT1 and CT1' may be formed within the first interlayer insulation layer 110 and the second interlayer insulation layer 120. Before forming the first contact electrodes CT1 and CT1', the upper surface of the second interlayer insulation layer 120 may be planarized by using a chemical mechanical polishing (CMP) process or the like.

The first portion 211 of the through via 210 and 210' and the first contact electrode CT1 and CT1' may be formed together in one process. In this case, the second interlayer insulation layer 120 is first formed, a groove for forming the first contact electrode CT1 and CT1' and a through hole for forming the first portion 211 of the through via 210 and 210' are formed, and then a conductive layer forming the first contact electrode CT1 and CT1' and the first portion 211 of the through via 210 and 210' may be formed.

Referring to FIG. 5A, the third interlayer insulation layer 130 may be formed on the second interlayer insulation layer 120, and the first upper wirings 132 and the first upper vias 134 may be formed within the third interlayer insulation layer 130. The fourth interlayer insulation layer 140 may be formed on the third interlayer insulation layer 130, and the second upper wirings 142 and the second upper vias 144 may be formed within the fourth interlayer insulation layer 140. Although not shown, additional interlayer insulation layers, additional upper wirings, and additional upper vias may be formed on the fourth interlayer insulation layer 140.

Referring to FIG. 5A, lower through holes exposing the first portion 211 of the through vias 210 and 210' are formed by photo-etching the semiconductor substrate 100 and the isolation layer ST, the side surface insulation layer 220 covering side surfaces of the lower through holes is formed, and the second portion 212 of the through vias 210 and 210' filling the lower through hole may be formed.

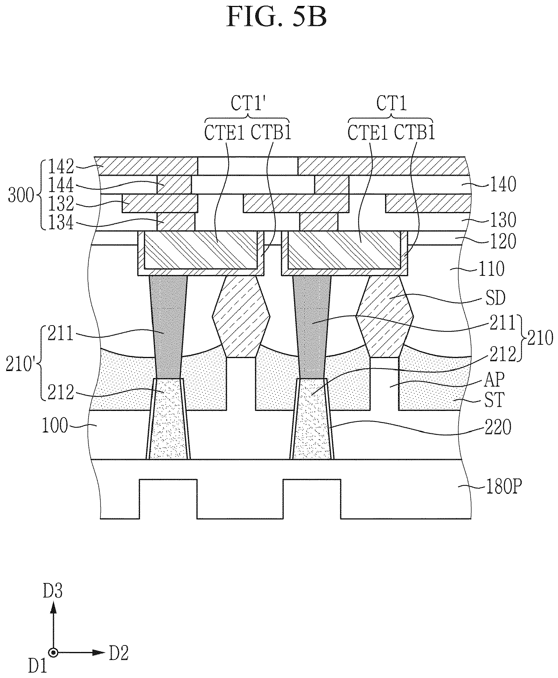

A preliminary first lower interlayer insulation layer 180P having an intaglio pattern for forming wires may be formed on, referring to FIG. 5B, the second surface 100b of the semiconductor substrate 100.

The preliminary first lower interlayer insulation layer 180P may be formed through depositing or coating an insulation layer and photo-etching.

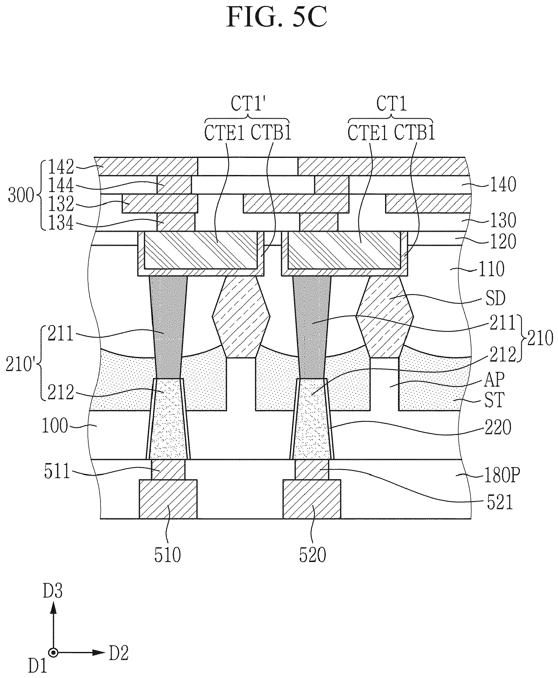

Subsequently, referring to FIG. 5C, via holes for forming the first lower vias 511 and 521 are formed in the preliminary first lower interlayer insulation layer 180P, and the first lower vias 511 and 521 filing the via holes and the metal power rail 510 and the metal ground rail 520 filling the intaglio pattern for forming wires are formed.

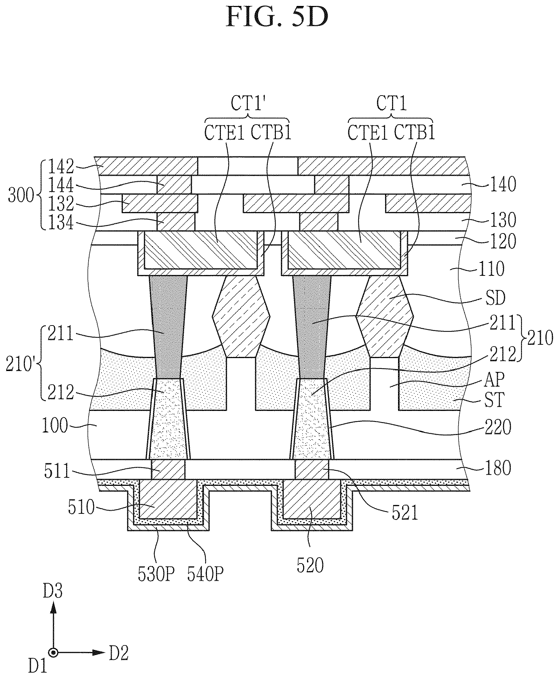

Subsequently, referring to FIG. 5D, the metal power rail 510 and the metal ground rail 520 are exposed by etching the preliminary first lower interlayer insulation layer 180P, and a preliminary dielectric layer 540P and a conductive layer 530P for the auxiliary electrode may be formed by conformally stacking the dielectric layer and the conductive layer. The etching of the preliminary first lower interlayer insulation layer 180P may be processed in an etch back method, through which the first lower interlayer insulation layer 180 may be formed.

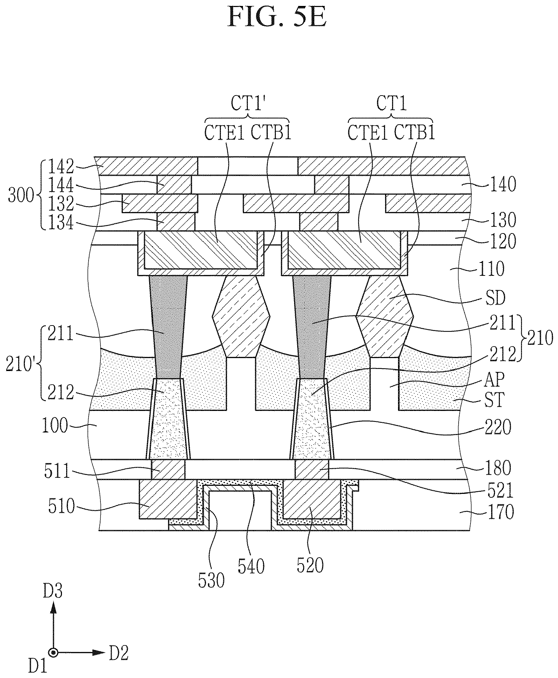

Subsequently, referring to FIG. 5E, the conductive layer 530P for the auxiliary electrode and the preliminary dielectric layer 540P are photo-etched, to form the auxiliary electrode 530 and the dielectric layer 540, and subsequently, the second lower interlayer insulation layer 170 burying the metal power rail 510, the metal ground rail 520, the dielectric layer 540, and the auxiliary electrode 530 may be formed.

Subsequently, referring to FIG. 3A, a lower wiring structure 400 including the second lower via 154 electrically connecting the auxiliary electrode 530 and the metal power rail 510 may be formed. The lower wiring structure 400 may include the lower wirings 152 and 162, second the lower vias 154 and 164 and the third and fourth lower interlayer insulation layers 150 and 160. The lower wirings 152 and 162 and second the lower vias 154 and 164 may include metal (e.g., copper).

Processes from FIG. 5B may be performed in a state where the carrier substrate is attached to the upper wiring structure 300, and the carrier substrate may be separated after forming the lower wiring structure 400.

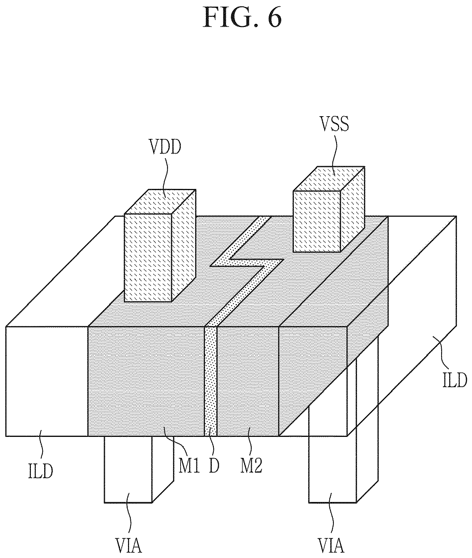

FIG. 6 is a perspective view illustrating a capacitor portion of a semiconductor device according to another embodiment.

The capacitor of a semiconductor device according to an embodiment of FIG. 6 may be decoupling capacitor, and may be implemented by using a wiring disposed on a surface of the semiconductor device. The decoupling capacitor may be disposed on the back side of the semiconductor device, and may be formed between the metal power rail M1 and the metal ground rail M2. The decoupling capacitor may include the dielectric layer D disposed between the metal power rail M1 and the metal ground rail M2. The dielectric layer D may include a material having a higher dielectric constant than silicon oxide (SiO₂), such as hafnium oxide (HfO), aluminum oxide (AlO), or tantalum oxide (TaO). The metal power rail M1 and the metal ground rail M2 may be disposed side by side for a desired and/or alternatively predetermined range to face each other, and boundaries between the metal power rail M1 and the metal ground rail M2 may be bent. Accordingly, the dielectric layer D may also be bent. The capacitance of the decoupling capacitor may be increased by bending the boundaries of the metal power rail M1 and the metal ground rail M2 that face each other.

The metal power rail M1 and the metal ground rail M2 may be connected to a power supply voltage or a ground voltage through the lower via VIA, respectively. Another connection wiring may be interposed between the lower via VIA and the power supply voltage or the ground voltage. The metal power rail M1 may be connected to the drain terminal of the semiconductor device through the upper via VDD, and the metal ground rail M2 may be connected to the source terminal of the semiconductor device through the upper via VSS.

The interlayer insulation layer ILD may be disposed around the metal power rail M1, the metal ground rail M2, the auxiliary electrode E, the dielectric layer D, the upper vias VDD, VSS and the lower vias VIA.

The capacitor of the semiconductor device according to an embodiment of FIG. 6 may replace the capacitor forming structure of the semiconductor device according to an embodiment of FIG. 2 and 3A to FIG. 3C or may be applied in parallel therewith.

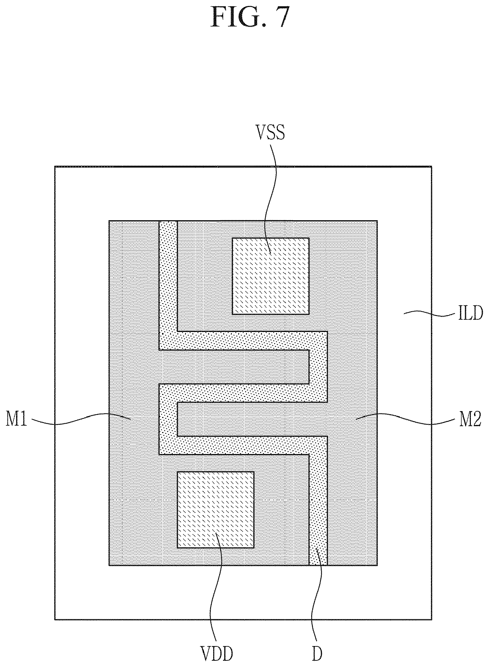

FIG. 7 is a layout view illustrating a capacitor portion of a semiconductor device according to another embodiment.

Compared to the capacitor of a semiconductor device according to an embodiment of FIG. 6, in the semiconductor device according to an embodiment of FIG. 7, the number of bends at the boundaries of the metal power rail M1 and the metal ground rail M2 facing each other is increased. Accordingly, the planar pattern of the dielectric layer D may have a meandering shape. The number of bends and the shape of bending of the boundaries of the metal power rail M1 and the metal ground rail M2 facing each other may be variously modified according to the capacitance of the capacitor to be implemented. For example, the bent portion may form a smooth curve.

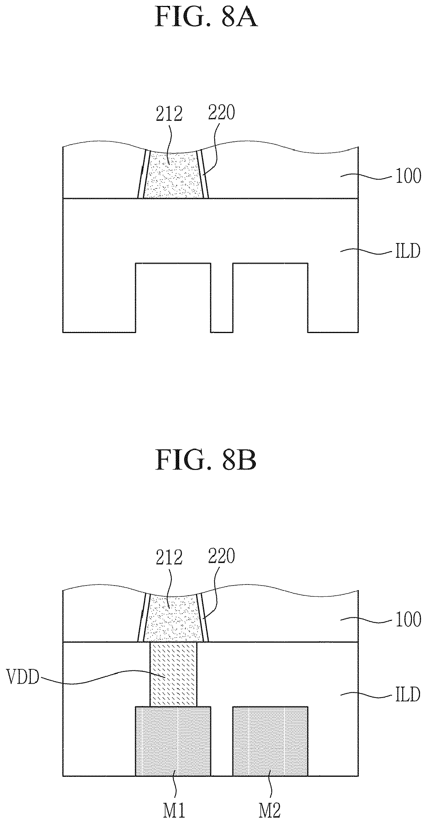

Hereinafter, a method of manufacturing a semiconductor device according to an embodiment of FIG. 6 or FIG. 7 is described with reference to FIG. 8A to FIG. 8E.

FIG. 8A to FIG. 8E are cross-sectional views sequentially illustrating a method of manufacturing the semiconductor device according to an embodiment of FIG. 6 or FIG. 7.

Referring to FIG. 8A, after the device structures within the semiconductor substrate 100, such as the gate structure, the source/drain patterns, the through vias, the contact electrodes, are formed, a preliminary interlayer insulation layer ILD having the intaglio pattern for forming wires may be formed on a lower surface (e.g., second surface) of the semiconductor substrate 100. The preliminary interlayer insulation layer ILD may be formed through depositing or coating an insulation layer and photo etching.

Subsequently, referring to FIG. 8B, via holes for forming the upper vias VDD and VSS are formed on the preliminary interlayer insulation layer ILD, and the upper vias VDD and VSS filling the via holes and the metal power rail M1 and the metal ground rail M2 filling the intaglio pattern for forming wires may be formed.

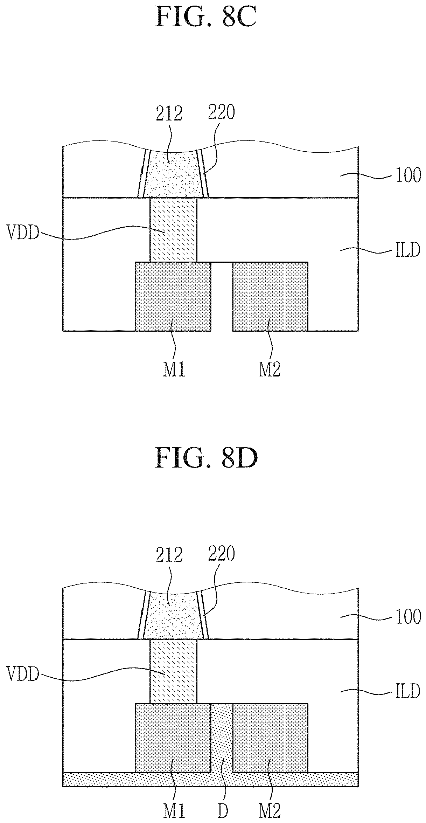

Subsequently, referring to FIG. 8C, a gap may be formed by removing the preliminary interlayer insulation layer ILD between the metal power rail M1 and the metal ground rail M2.

Subsequently, referring to FIG. 8D, the dielectric layer D filling the gap between the metal power rail M1 and the metal ground rail M2 may be conformally formed on a lower surface of the semiconductor substrate 100.

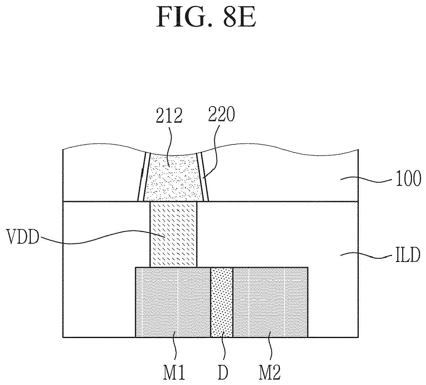

Subsequently, referring to FIG. 8E, the dielectric layer D is etched back or chemical mechanical polishing (CMP) is performed thereon such that the dielectric layer D filling the gap between the metal power rail M1 and the metal ground rail M2 is maintained and others are removed.

Subsequently, referring to FIG. 6, the lower wiring structure including the lower via VIA connected to the metal power rail M1 and the metal ground rail M2 may be formed.

As such, by implementing the decoupling capacitor using the power delivery network, wiring may be efficiently arranged. Accordingly, performance of the semiconductor device may be improved.

While this disclosure has been described in connection with some example embodiments, it is to be understood that inventive concepts are not limited to the disclosed embodiments, but, on the contrary, is intended are cover various modifications and equivalent arrangements included within the scope of the appended claims.

## Claims

1. A semiconductor device, comprising:
a semiconductor substrate (100) having a first surface (100a) and a second surface (100b) opposite to each other;
a channel pattern (CH) on the first surface (100a) of the semiconductor substrate (100);
source/drain patterns (SD) on the first surface (100a) of the semiconductor substrate (100), the source/drain patterns being on both sides of the channel pattern (CH);
a contact electrode (CT1; CT1') electrically connected to the source/drain patterns (SD);
a lower wiring structure (400) on the second surface (100b) of the semiconductor substrate (100); and
a through via (210; 210') penetrating the semiconductor substrate (100) and connecting the contact electrode (CT1; CT1') and the lower wiring structure (400) to each other, wherein
the lower wiring structure (400) includes a first metal line (M1; 510) configured to receive a first voltage, a second metal line (M2; 520) configured to receive a second voltage.

2. The semiconductor device of claim 1, wherein the lower wiring structure (400) further includes an auxiliary electrode (E; 530) electrically connected to one of the first metal line (M1; 510) and the second metal line (M2; 520), and
the auxiliary electrode (E; 530) overlaps an other of the first metal line (M1; 510) and the second metal line (M2; 520) in a state insulated from the other of the first metal line (M1; 510) and the second metal line (M2; 520).

3. The semiconductor device of claim 2, wherein
the lower wiring structure (400) further comprises an interlayer insulation layer (ILD; 180, 170, 160, 150) and a dielectric layer (D; 540),
the interlayer insulation layer (ILD; 180, 170, 160, 150) insulates the first metal line (M1; 510) and the second metal line (M2; 520) from other wires, and
the dielectric layer (D; 540) is between the auxiliary electrode (E; 530) and the first metal line (M1; 510) and between the auxiliary electrode (E; 530) and the second metal line (M2; 520).

4. The semiconductor device of claim 3, wherein a dielectric constant of the dielectric layer (D; 540) is higher than a dielectric constant of the interlayer insulation layer (ILD; 180, 170, 160, 150).

5. The semiconductor device of claim 4, wherein the dielectric layer (D; 540) comprises at least one of hafnium oxide (HfO), aluminum oxide (AlO), or tantalum oxide (TaO).

6. The semiconductor device of claim 2, further comprising:
a first interlayer insulation layer (180); and
a first via (511; 521), wherein
the first metal line (M1; 510) and the second metal line (M2; 520) face the second surface of the semiconductor substrate (100),
the first interlayer insulation layer (180) is between the second surface (100b) of the semiconductor substrate (100) and each of the first metal line (M1; 510) and the second metal line (M2; 520),
one of the first metal line (M1; 510) and the second metal line (M2; 520) is electrically connected to the through via (210; 210') by the first via (511; 521), and
the first via (511; 521) penetrates the first interlayer insulation layer (180).

7. The semiconductor device of claim 6, wherein
the lower wiring structure (400) further comprises a second interlayer insulation layer (170), a lower wiring (152) under the second interlayer insulation layer (170), and a second via (154) penetrating the second interlayer insulation layer and the lower wiring,
the second interlayer insulation layer (170) buries the first metal line (M1; 510), the second metal line (M2; 520), and the auxiliary electrode (E; 530),
the second via (154) penetrates the second interlayer insulation layer (170) to electrically connect the lower wiring (152) and the first metal line (M1; 510),
the second via (154) is also connected to the auxiliary electrode (E; 530), and
the second via (154) electrically connects the auxiliary electrode (E; 530) to the first metal line (M1; 510).

8. The semiconductor device of claim 7, wherein
the lower wiring structure (400) further comprises a dielectric layer (D; 540) between the auxiliary electrode (E; 530) and the first metal line (M1; 510) and between the auxiliary electrode (E; 530) and the second metal line (M2; 520), and
a dielectric constant of the dielectric layer (D; 540) is higher than a dielectric constant of the first interlayer insulation layer (180) and a dielectric constant of the second interlayer insulation layer (170).

9. The semiconductor device of claim 1 or 2, wherein
boundaries of the first metal line (M1; 510) and the second metal line (M2; 520) facing each other are bent in a same pattern.

10. The semiconductor device of claim 9, wherein
the lower wiring structure (400) further comprises an interlayer insulation layer (ILD; 180, 170, 160, 150) and a dielectric layer (D; 540),
the interlayer insulation layer (ILD; 180, 170, 160, 150) insulates the first metal line (M1; 510) and the second metal line (M2; 520) from other wires, and
the dielectric layer (D; 540) is between the first metal line (M1; 510) and the second metal line (M2; 520).

11. The semiconductor device of claim 10, wherein a dielectric constant of the dielectric layer (D; 540) is higher than a dielectric constant of the interlayer insulation layer (ILD; 180, 170, 160, 150).

12. The semiconductor device of claim 11, wherein a planar pattern of the dielectric layer (D; 540) has a meandering shape.

13. The semiconductor device of any one of the preceding claims, wherein
the first voltage is a power supply voltage, and
the second voltage is a ground voltage.

14. A method of manufacturing a semiconductor device, the method comprising:
forming a channel pattern (CH) and source/drain patterns (SD) on a first surface (100a) of a semiconductor substrate (100), the semiconductor substrate (100) having a second surface (100b) opposite to the first surface (100a) of the semiconductor substrate (100);
forming a through via (210; 210') penetrating the semiconductor substrate (100);
forming a preliminary first lower interlayer insulation layer (180P) having an intaglio pattern on the second surface (100b) of the semiconductor substrate (100);
forming a first lower via (511; 521), the first lower via (511; 521) penetrating the preliminary first lower interlayer insulation layer (180P) and being connected to the through via (210; 210'), and forming a first metal line (M1; 510) and a second metal line (M2; 520) filling the intaglio pattern;
forming a first lower interlayer insulation layer (180) by partially removing the preliminary first lower interlayer insulation layer (180P) to expose the first metal line (M1; 510) and the second metal line (M2; 520);
stacking a preliminary dielectric layer (540P) and a conductive layer (530P) on the first metal line (M1; 510) and the second metal line (M2; 520) such that the preliminary dielectric layer (540P) and the conductive layer (530P) cover the first metal line (M1; 520) and the second metal line (M2; 520); and
forming a dielectric layer (D; 540) and an auxiliary electrode by patterning the preliminary dielectric layer (540P) and the conductive layer (530P) into the dielectric layer (D; 540) and the auxiliary electrode (E; 530).

15. The method of claim 14, after the forming the dielectric layer (D; 540) and the auxiliary electrode (E; 530), further comprising:
forming a second lower interlayer insulation layer (170), the second lower interlayer insulation layer (170) burying the first metal line (M1; 510), the second metal line (M2; 520), the dielectric layer (540), and the auxiliary electrode (E; 530);
forming a lower wiring structure (400), the lower wiring structure (400) including a second lower via (154) penetrating the second lower interlayer insulation layer (170) and electrically connecting the auxiliary electrode (E; 530) to the first metal line (M1; 510);
forming contact electrodes (CT1; CT1') electrically connected to the source/drain patterns (SD) on the first surface (100a) of the semiconductor substrate (100); and
forming an upper wiring structure (300), the upper wiring structure (300) being connected to at least a portion of the contact electrodes (CT1; CT1').

## Amended claims

### Amended claims in accordance with Rule 137(2) EPC.

1. A semiconductor device, comprising:
a semiconductor substrate (100) having a first surface (100a) and a second surface (100b) opposite to each other;
a channel pattern (CH) on the first surface (100a) of the semiconductor substrate (100);
source/drain patterns (SD) on the first surface (100a) of the semiconductor substrate (100), the source/drain patterns being on both sides of the channel pattern (CH);
a contact electrode (CT1; CT1') electrically connected to the source/drain patterns (SD);
a lower wiring structure (400) on the second surface (100b) of the semiconductor substrate (100);
a first interlayer insulation layer (180);
a through via (210; 210') penetrating the semiconductor substrate (100) and connecting the contact electrode (CT1; CT1') and the lower wiring structure (400) to each other; and
a first lower via (511; 521) penetrating the first interlayer insulation layer (180) and being connected to the through via (210;210'), wherein
the lower wiring structure (400) includes a first metal line (M1; 510) configured to receive a first voltage, a second metal line (M2; 520) configured to receive a second voltage, an auxiliary electrode (E; 530) electrically connected to one of the first metal line (M1; 510) and the second metal line (M2; 520), and a dielectric layer (D; 540) that is between the auxiliary electrode (E; 530) and the first metal line (M1; 510) and between the auxiliary electrode (E; 530) and the second metal line (M2; 520),
wherein the auxiliary electrode (E; 530) overlaps an other of the first metal line (M1; 510) and the second metal line (M2; 520) in a state insulated from the other of the first metal line (M1; 510) and the second metal line (M2; 520), and
**characterized in that**
at least a portion of the auxiliary electrode (E; 530) is between the first metal line (M1; 510) and the second metal line (M2; 520).

2. The semiconductor device of claim 1, wherein
the lower wiring structure (400) further comprises a second interlayer insulation layer (ILD; 170, 160, 150)
the second interlayer insulation layer (ILD; 170) insulates the first metal line (M1; 510) and the second metal line (M2; 520) from other wires.

3. The semiconductor device of claim 2, wherein a dielectric constant of the dielectric layer (D; 540) is higher than a dielectric constant of the first interlayer insulation layer (180) and a dielectric constant of the second interlayer insulation layer (170).

4. The semiconductor device of claim 3, wherein the dielectric layer (D; 540) comprises at least one of hafnium oxide (HfO), aluminum oxide (AlO), or tantalum oxide (TaO).

5. The semiconductor device of claim 1, wherein:
the first metal line (M1; 510) and the second metal line (M2; 520) face the second surface of the semiconductor substrate (100),
the first interlayer insulation layer (180) is between the second surface (100b) of the semiconductor substrate (100) and each of the first metal line (M1; 510) and the second metal line (M2; 520),
one of the first metal line (M1; 510) and the second metal line (M2; 520) is electrically connected to the through via (210; 210') by the first via (511; 521).

6. The semiconductor device of claim 5, wherein
the lower wiring structure (400) further comprises a second interlayer insulation layer (170), a lower wiring (152) under the second interlayer insulation layer (170), and a second via (154) penetrating the second interlayer insulation layer (170) and the lower wiring (152),
the second interlayer insulation layer (170) buries the first metal line (M1; 510), the second metal line (M2; 520), and the auxiliary electrode (E; 530),
the second via (154) penetrates the second interlayer insulation layer (170) to electrically connect the lower wiring (152) and the first metal line (M1; 510),
the second via (154) is also connected to the auxiliary electrode (E; 530), and
the second via (154) electrically connects the auxiliary electrode (E; 530) to the first metal line (M1; 510).

7. The semiconductor device of claim 6, wherein
the lower wiring structure (400) further comprises a dielectric layer (D; 540) between the auxiliary electrode (E; 530) and the first metal line (M1; 510) and between the auxiliary electrode (E; 530) and the second metal line (M2; 520), and
a dielectric constant of the dielectric layer (D; 540) is higher than a dielectric constant of the first interlayer insulation layer (180) and a dielectric constant of the second interlayer insulation layer (170).

8. The semiconductor device of claim 1, wherein
boundaries of the first metal line (M1; 510) and the second metal line (M2; 520) facing each other are bent in a same pattern.

9. The semiconductor device of claim 8, wherein
the lower wiring structure (400) further comprises a second interlayer insulation layer (ILD; 170),
the interlayer insulation layer (ILD; 170) insulates the first metal line (M1; 510) and the second metal line (M2; 520) from other wires, and
the dielectric layer (D; 540) is between the first metal line (M1; 510) and the second metal line (M2; 520).

10. The semiconductor device of claim 9, wherein a dielectric constant of the dielectric layer (D; 540) is higher than a dielectric constant of the first interlayer insulation layer (180) and a dielectric constant of the second interlayer insulation layer (ILD, 170).

11. The semiconductor device of claim 10, wherein a planar pattern of the dielectric layer (D; 540) has a meandering shape.

12. The semiconductor device of any one of the preceding claims, wherein
the first voltage is a power supply voltage, and
the second voltage is a ground voltage.

13. A method of manufacturing a semiconductor device, the method comprising:
forming a channel pattern (CH) and source/drain patterns (SD) on a first surface (100a) of a semiconductor substrate (100), the semiconductor substrate (100) having a second surface (100b) opposite to the first surface (100a) of the semiconductor substrate (100);
forming a through via (210; 210') penetrating the semiconductor substrate (100);
forming a preliminary first lower interlayer insulation layer (180P) having an intaglio pattern on the second surface (100b) of the semiconductor substrate (100);
forming a first lower via (511; 521), the first lower via (511; 521) penetrating the preliminary first lower interlayer insulation layer (180P) and being connected to the through via (210; 210'), and forming a first metal line (M1; 510) and a second metal line (M2; 520) filling the intaglio pattern;
forming a first lower interlayer insulation layer (180) by partially removing the preliminary first lower interlayer insulation layer (180P) to expose the first metal line (M1; 510) and the second metal line (M2; 520);
stacking a preliminary dielectric layer (540P) and a conductive layer (530P) on the first metal line (M1; 510) and the second metal line (M2; 520) such that the preliminary dielectric layer (540P) and the conductive layer (530P) cover the first metal line (M1; 520) and the second metal line (M2; 520); and
forming a dielectric layer (D; 540) and an auxiliary electrode by patterning the preliminary dielectric layer (540P) and the conductive layer (530P) into the dielectric layer (D; 540) and the auxiliary electrode (E; 530).

14. The method of claim 13, after the forming the dielectric layer (D; 540) and the auxiliary electrode (E; 530), further comprising:
forming a second lower interlayer insulation layer (170), the second lower interlayer insulation layer (170) burying the first metal line (M1; 510), the second metal line (M2; 520), the dielectric layer (540), and the auxiliary electrode (E; 530);
forming a lower wiring structure (400), the lower wiring structure (400) including a second lower via (154) penetrating the second lower interlayer insulation layer (170) and electrically connecting the auxiliary electrode (E; 530) to the first metal line (M1; 510);
forming contact electrodes (CT1; CT1') electrically connected to the source/drain patterns (SD) on the first surface (100a) of the semiconductor substrate (100); and
forming an upper wiring structure (300), the upper wiring structure (300) being connected to at least a portion of the contact electrodes (CT1; CT1').
